# EUROPEAN PATENT SPECIFICATION

(11) **EP 1 161 660 B1**
(45) Date of publication and mention of the grant of the patent: **05.10.2005**
(21) Application number: 98959236.5
(22) Date of filing: 27.11.1998
(51) Int. Cl.: G01J 5/20, H01L 31/0216

(54) **BOLOMETER WITH A ZINC OXIDE BOLOMETER ELEMENT**
BOLOMETER MIT BOLOMETRISCHEM ZINKOXIDELEMENT
BOLOMETRE AVEC ELEMENT BOLOMETRIQUE EN OXYDE DE ZINC

(43) Date of publication of application: 12.12.2001
(73) Proprietor: Daewoo Electronics Corporation, Seoul (KR)
(72) Inventor: YONG, Yoon, Joong-Video Res. Cent. Daewoo Elec. Co, Seoul 100-095 (KR)
(74) Representative: Turi, Michael
(86) International application number: PCT/KR1998/000382
(87) International publication number: WO 2000/033040

(56) References cited:
- WO-A1-93/09414
- US-A- 5 572 029
- US-A- 5 831 266

## Description

### TECHNICAL FIELD OF THE INVENTION

The present invention relates to an infra-red bolometer; and, more particularly, to the infra-red bolometer incorporating therein a zinc oxide bolometer element.

### BACKGROUND ART

A radiation detector is a device that produces an output signal which is a function of the amount of radiation that is incident upon an active region of the detector. Infra-red detectors are those detectors which are sensitive to radiation in the infra-red region of the electromagnetic spectrum. There are two types of infra-red detectors, thermal detectors including bolometers and photon detectors.

The photon detectors function based upon the number of photons that are incident upon and interact with electrons in a transducer region of the detector. The photon detectors, since they function based on direct interactions between electrons and photons, are highly sensitive and have a high response speed compared to the bolometers. However, they have a shortcoming in that the photon detectors operate well only at low temperatures which necessitates to incorporate therein an additional cooling system.

The bolometers function, on the other hand, based upon a change in the temperature of the transducer region of the detector due to absorption of the radiation. The bolometers provide an output signal, i.e., a change in the resistance of materials (called bolometer elements), that is proportional to the temperature of the transducer region. The bolometer elements have been made from both metals and semiconductors. In metals, the resistance change is essentially due to variations in the carrier mobility, which typically decreases with temperature. Greater sensitivity can be obtained in high-resistivity semiconductor bolometer elements in which the free-carrier density is an exponential function of temperature.

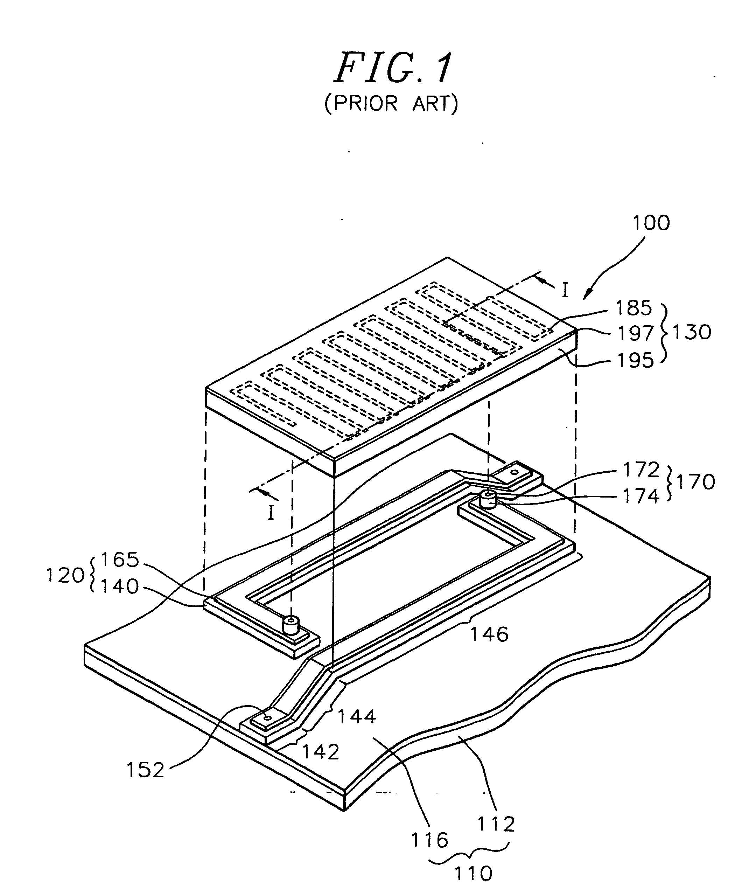

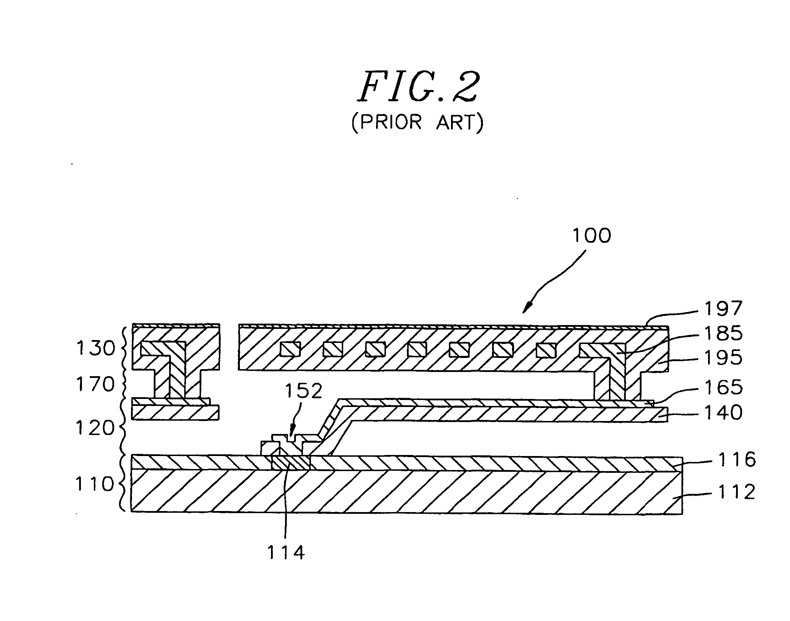

In Figs. 1 and 2, there are shown a perspective view and a cross sectional view illustrating a three-level bolometer 100 of the priort art disclosed in U.S. Ser. Application entitled "BOLOMETER HAVING AN INCREASED FILL FACTOR". The bolometer 100 comprises an active matrix level 110, a support level 120, a pair of posts 170 and an absorption level 130.

The active matrix level 110 has a substrate 112 including an integrated circuit (not shown), a pair of connecting terminals 114 and a protective layer 116. Each of the connecting terminals 114 made of a metal is located on top of the substrate 112. The protective layer 116 made of, e.g., silicon nitride (SiNₓ), covers the substrate 112. The pair of connecting terminals 114 are electrically connected to the integrated circuit.

The support level 120 includes a pair of bridges 140 made of silicon nitride (SiNₓ), each of the bridges 140 having a conduction line 165 formed on top thereof. Each of the bridges 140 is provided with an anchor portion 142, a leg portion 144 and an elevated portion 146, the anchor portion 142 including a via hole 152 through which one end of the conduction line 165 is electrically connected to the connecting terminal 114, the leg portion 144 supporting the elevated portion 146.

The absorption level 130 is provided with a serpentine bolometer element 185 surrounded by an absorber 195 and an IR absorber coating 197 formed on top of the absorber 195. The absorber 195 is fabricated by depositing silicon nitride before and after the formation of the serpentine bolometer element 185 to surround the serpentine bolometer element 185. Titanium (Ti) is chosen as the material for bolometer element 185 because of the ease with which it can be formed.

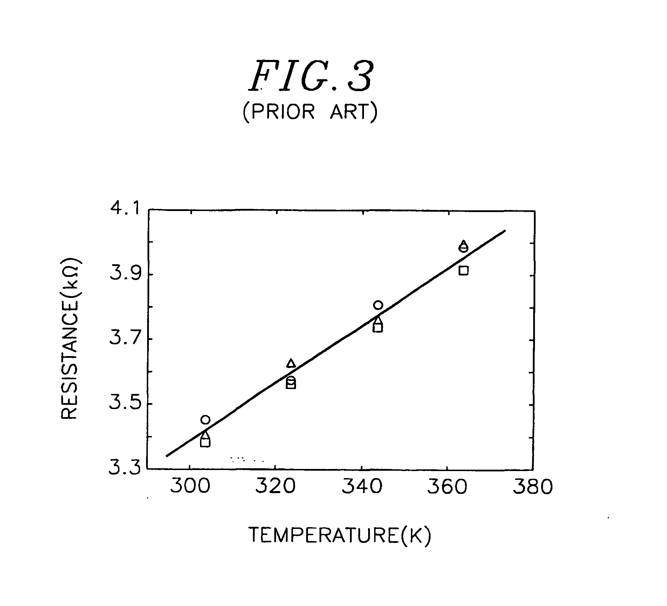

The resistance in the titanium bolometer element 185, as shown in Fig. 3, exhibits a positive, linear dependence on temperature. The temperature coefficient of the resistance (TCR) of the titanium bolometer element 185 is 0.25% K⁻¹ at 300 K.

Returning to Figs. 1 and 2, each of the posts 170 is placed between the absorption level 130 and the support level 120. Each of the posts 170 includes an electrical conduit 172 made of a metal, e.g., titanium (Ti), and surrounded by an insulating material 174 made of, e.g., silicon nitride (SiNₓ). Top end of the electrical conduit 172 is electrically connected to one end of the serpentine bolometer element 185 and bottom end of the electrical conduit 172 is electrically connected to the conduction line 165 on the bridge 140, in such a way that both ends of the serpentine bolometer element 185 in the absorption level 130 is electrically connected to the integrated circuit of the active matrix level 110 through the electrical conduits 172, the conduction lines 165 and the connecting terminals 114. When exposed to infra-red radiation, the resistivity of the serpentine bolometer element 185 increases, causing a current and a voltage to vary, accordingly. The varied current or voltage is amplified by the integrated circuit, in such a way that the amplified current or voltage is read out by a detective circuit (not shown).

There are certain deficiencies associated with the above described three-level bolometer 100. For example, during the formation of the absorber 195 made of silicon nitride (SiNₓ), since silicon nitride (SiNₓ) can be formed only at a relatively high temperature, e.g., over 850 °C, titanium (Ti) constituting the serpentine bolometer element 185 gets easily oxidized, which will, in turn, detrimentally affect the temperature coefficient of resistance (TCR) thereof. Further, since the bolometer element 185 is made of a titanium, the sensitivity of the bolometer 100 is less than desired.

Document WO 93/09414 discloses a thin film pyroelectric imaging array where zinc oxide is mentionned as a possible choice amongst 6 materials. Document US 5,572,029 discloses a thermal detector having thermal isolation.

### DISCLOSURE OF THE INVENTION

It is, therefore, a primary object of the present invention to provide an infra-red bolometer including a bolometer element which is stable at high temperatures and has a high temperature coefficient of resistance (TCR).

In accordance with one aspect of the present invention, there is provided an infra-red bolometer, which comprises: an active matrix level including a substrate and at least a pair of connecting terminals; a support level provided with at least a pair of bridges, each of the bridges including an conduction line, one end of the conduction line being electrically connected to the respective connecting terminal; an absorption level including a zinc oxide bolometer element surrounded by an absorber; and at least a pair of posts, each of the posts being placed between the absorption level and the support level and including an electrical conduit surrounded by an insulating material, each end of the bolometer element of the absorption level being electrically connected to the respective connecting terminal through the respective electrical conduit and the respective conduction line.

### BRIEF DESCRIPTION OF THE DRAWINGS

The above and other objects and features of the present invention will become apparent from the following description of the preferred embodiments given in conjunction with the accompanying drawings, wherein:
Fig. 1 shows a perspective view setting forth an infra-red bolometer previous disclosed;
Fig. 2 present a schematic cross sectional view depicting the infra-red bolometer shown in Fig. 1;
Fig. 3 exhibits resistance changes in the titanium bolometer element as a function of temperature;
Fig. 4 depicts a schematic cross sectional view setting forth an infra-red bolometer in accordance with the present invention; and
Fig. 5 provides resistance changes in the zinc oxide bolometer element as a function of temperature.

### MODES OF CARRYING OUT THE INVENTION

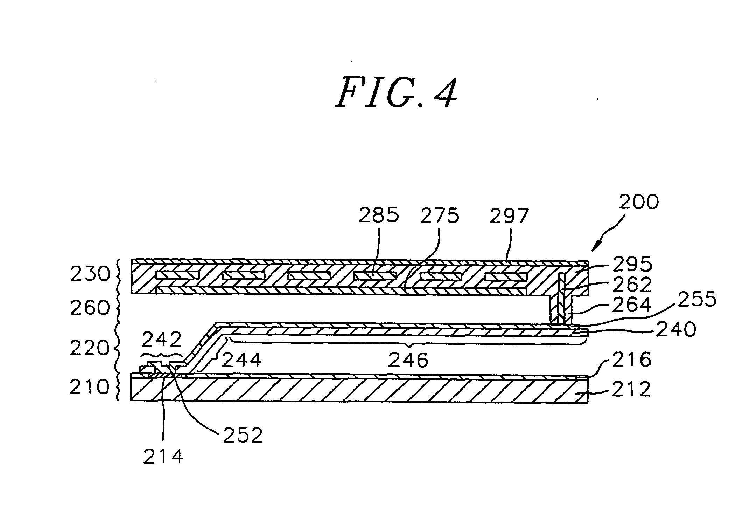

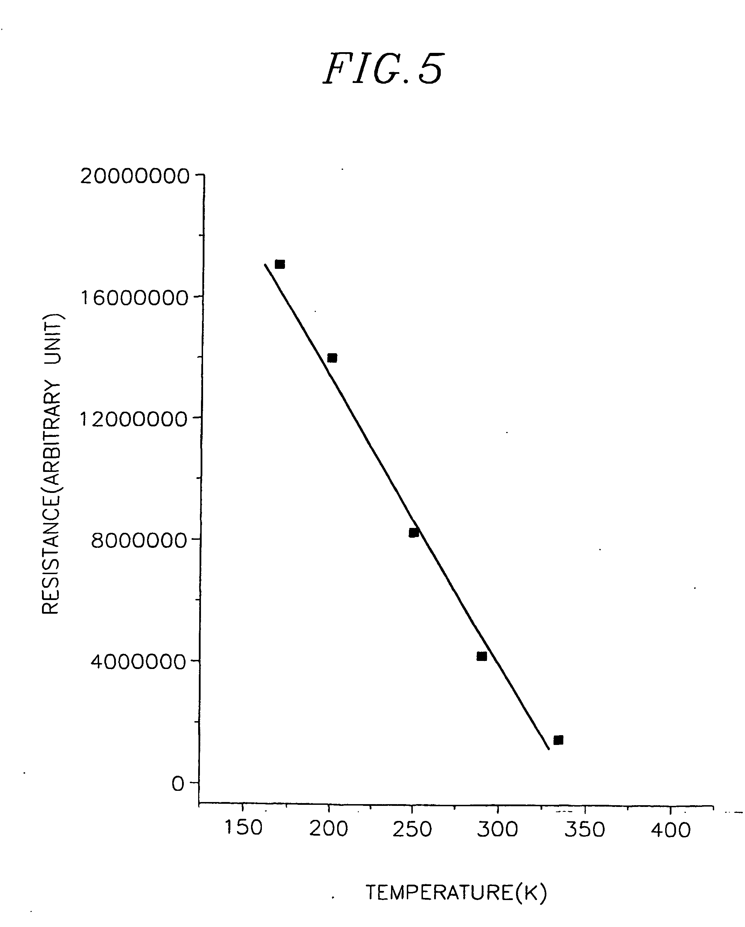

There are provided in Figs. 4 and 5 a schematic cross sectional view setting forth an infra-red bolometer 200 and resistance changes in the zinc oxide bolometer element as a function of temperature in accordance with an embodiment of the present invention, respectively.

The bolometer 200 shown in Fig. 4 comprises an active matrix level 210, a support level 220, at least a pair of posts 260 and an absorption level 230.

The active matrix level 210 has a substrate 212 including an integrated circuit (not shown), a pair of connecting terminals 214 and a protective layer 216. Each of the connecting terminals 214 made of a metal is located on top of the substrate 212. The pair of connecting terminals 214 are electrically connected to the integrated circuit. The protective layer 216 made of, e.g., silicon nitride (SiNₓ) covers the substrate 212.

The support level 220 includes a pair of bridges 240 made of an insulating material, e.g., silicon nitride (SiNₓ), silicon oxide (SiO₂) and silicon oxy-nitride (SiOₓN_{y}), wherein each of the bridges 240 has a conduction line 255, the conduction line 255 being made of a metal, e.g., aluminum (Al), lead (Pt) or titanium (Ti), and formed on top thereof. Each of the bridges 240 is provided with an anchor portion 242, a leg portion 244 and an elevated portion 246, the anchor portion 242 including a via hole 252 through which one end of the conduction line 255 is electrically connected to the connecting terminal 214, the leg portion 244 supporting the elevated portion 246.

The absorption level 230 is provided with a bolometer element 285 surrounded by an absorber 295, an reflective layer 275 formed at bottom of the absorber 295 and an IR absorber coating 297 positioned on top of the absorber 295. The absorber 295 is made of an insulating material, e.g., silicon nitride (SiNₓ), silicon oxide (SiOₓ) or silicon oxy-nitride (SiOₓN_{y}), which is characterized by a low heat-conductivity. The reflective layer 275 is made of a metal, e.g., Al or Pt, and is used for returning the transmitted IR back to the absorber 295. The IR absorber coating 297 is made of, e.g., black gold, and is used for reinforcing an absorption efficiency for the incident IR. When selecting a material for bolometer element 285, it is important to consider the material characteristics. The material, in addition to exhibiting a high temperature coefficiency of resistance (TCR), must be stable at high-temperatures since the silicon based materials used in forming the bolometers are usually formed at high temperatures. For this reason, zinc oxide is chosen as a material for the bolometer element 285 in the present ivention.

The conductivity of zinc oxide (ZnOₓ) is dependent on its thickness and oxidation vacancy. Experimentally, it is found that the maxinum temperature coefficiency of resistance (TCR) is obtained in the zinc oxide bolometer element 285 when it has a thickness of 100Å - 10µm with a molar-ratio (x) in a range of 0.5 - 1.5.

Fig. 5 provides graphically a relationship between resistivity and temperature of the zinc oxide bolometer element 285. The zinc oxide bolometer element 285 unlike the titanium bolometer element 185 of the prior art bolometer 100, exhibits a negative temperature dependence and the temperature coefficient of the resistance (TCR) of the zinc oxide bolometer element 285 is -2.75% K⁻¹ at 300 K.

Returning to Fig. 4, each of the posts 260 is placed between the absorption level 230 and the support level 220. Each of the post 260 includes an electrical conduit 262 made of a metal, e.g., aluminum (Al), lead (Pt) or titanium (Ti), and surrounded by an insulating material 264 made of, e.g., silicon nitride (SiNₓ), silicon oxide (SiOₓ) or silicon oxy-nitride (SiOₓN_{y}). Top end of the electrical conduit 262 is electrically connected to one end of the zinc oxide bolometer element 285 and bottom end of the electrical conduit 262 is electrically connected to the conduction line 255 on the bridge 240, in such a way that both ends of the zinc oxide bolometer element 285 in the absorption level 230 is electrically connected to the integrated circuit of the active matrix level 210 through the electrical conduits 262, the conduction lines 255 and the connecting terminals 214. When infra-red energy is absorbed, the resistivity of the zinc oxide bolometer element 285 decreases which is read out by a detective circuit (not shown).

In the infra-red bolometer 200 of the present invention, the bolometer element 285 is made of a zinc oxide having a stability in high temperatures, which will, in turn, make the use of high-temperature processes possible during the fabrication of the bolometer 200. Further, the zinc oxide bolometer element 285 has a high temperature coefficient of resistance, giving a relatively high sensitivity to the bolometer 200.

## Claims

1. A infra-red bolometer (200) comprising:
an active matrix level (210) including a substrate (212) and at least a pair of connecting terminals (214);
a support level (220) provided with at least a pair of bridges (240), each of the bridges (240) including a conduction line (255), one end of the conduction line (255) being electrically connected to the respective connecting terminal (214);
**characterized in that** it further comprises:
an absorption level (230) including a zinc oxide (ZnOₓ) bolometer element (285) surrounded by an absorber (295); and
at least a pair of posts (260), each of the posts (260) being placed between the absorption level (230) and the support level (220) and including an electrical conduit (262) surrounded by an insulating material (264), each end of the bolometer element (285) of the absorption level (230) being electrically connected to the respective connecting terminal (214) through the respective electrical conduit (262) and the respective conduction line (255).

2. The bolometer (200) of claim 1, wherein the zinc oxide bolometer element (285) has a thickness of 100Å - 10µm.

3. The bolometer (200) of claim 1, wherein the bolometer element (285) has a molar-ratio (x) in a range of 0.5 - 1.5.

4. The bolometer (200) of claim 1, wherein the absorption level (230) further includes a reflective layer (275) and an IR absorber coating (297).

5. The bolometer of claim 4, wherein the reflective layer (275) is formed at bottom of the absorber.

6. The bolometer of claim 5, wherein the reflective layer (275) is made of aluminum (Al).

7. The bolometer of claim 4, wherein the IR absorber coating (297) is formed on top of the absorber.

8. The bolometer of claim 1, wherein the conduction line (255) and the electrical conduit (262) are made of a metal.

9. The bolometer of claim 8, wherein the conduction line (255) and the electrical conduit (262) are made of Al, Pt or Ti.

## Patentansprüche

1. Infrarotempfindliches Bolometer (200) umfassend:
ein Aktivmatrixniveau (210), aufweisend ein Substrat (212) und wenigstens ein Paar Verbindungsanschlüsse (214);
ein Trägerniveau (220), das mit wenigstens einem Paar Brücken (240) versehen ist, wobei jede der Brücken (240) eine Leitung (255) aufweist, wobei ein Ende der Leitung (255) elektrisch verbunden ist mit dem jeweiligen Verbindungsanschluß (214); **dadurch gekennzeichnet, daß** es weiters umfaßt:
ein Absorptionsniveau (230) aufweisend ein bolometrisches Zinkoxid (ZnOx)-Element (285), das von einem Absorber (295) umgeben ist; und
wenigstens ein Paar Stützen (260), wobei jede der Stützen (260) zwischen dem Absorptionsniveau (230) und dem Trägerniveau (220) angeordnet ist und einen elektrischen Leiter (262) aufweist, der von einem isolierenden Material (264) umgeben ist, wobei jedes Ende des bolometrischen Elements (285) des Absorptionsniveaus (230) elektrisch mit dem jeweiligen Verbindungsanschluß (214) über den entsprechenden elektrischen Leiter (262) und
die entsprechende Leitung (255) verbunden ist.

2. Bolometer (200) nach Anspruch 1, bei welchem das bolometrische Zinkoxidelement (285) eine Dicke von 100 Å bis 10 µm hat.

3. Bolometer (200) nach Anspruch 1, bei welchem das bolometrische Element (285) ein Molverhältnis (x) in einem Bereich von 0,5-1,5 hat.

4. Bolometer (200) nach Anspruch 1, bei welchem das Absorptionsniveau (230) weiters eine reflektierende Schicht (275) und eine IR-Strahlung absorbierende Beschichtung (297) aufweist.

5. Bolometer nach Anspruch 4, bei welchem die reflektierende Schicht (275) am Boden des Absorbers ausgebildet ist.

6. Bolometer nach Anspruch 5, bei welchem die reflektierende Schicht (275) aus Aluminium (Al) hergestellt ist.

7. Bolometer nach Anspruch 4, bei welchem die IR-Strahlung absorbierende Schicht (297) oben auf dem Absorber ausgebildet ist.

8. Bolometer nach Anspruch 1, bei welchem die Leitung (255) und der elektrische Leiter (262) aus Metall hergestellt sind.

9. Bolometer nach Anspruch 8, bei welchem die Leitung (255) und der elektrische Leiter (262) aus Al, Pt oder Ti hergestellt sind.

## Revendications

1. Bolomètre infra-rouge (200), comprenant :
un niveau de matrice active (210) comprenant un substrat (212) et au moins une paire de bornes de raccordement (214) ;
un niveau de support (220) fourni avec au moins une paire de ponts (240), chacun des ponts (240) comprenant une ligne de conduction (255), une extrémité de la ligne de conduction (255) étant raccordée électriquement à la borne de raccordement (214) respective ; **caractérisé en ce qu'**il comprend en outre :
un niveau d'absorption (230) comprenant un élément bolométrique en oxyde de zinc (ZnOₓ) (285) entouré d'un absorbeur (295) ; et
au moins une paire de tiges (260), chacune des tiges (260) étant placée entre le niveau d'absorption (230) et le niveau de support (220), et comprenant un conduit électrique (262) entouré d'un matériau isolant (264), chaque extrémité de l'élément bolométrique (285) du niveau d'absorption (230) étant raccordée électriquement à la borne de raccordement (214) respective par le conduit électrique (262) respectif et la ligne de conduction (255) respective.

2. Bolomètre (200) selon la revendication 1, dans lequel l'élément bolométrique en oxyde de zinc (285) a une épaisseur de 100 angströms à 10 µm.

3. Bolomètre (200) selon la revendication 1, dans lequel l'élément bolométrique (285) a un rapport molaire (x) dans une plage de 0,5 à 1,5.

4. Bolomètre (200) selon la revendication 1, dans lequel le niveau d'absorption (230) comprend en outre une couche réfléchissante (275) et un revêtement d'absorbeur d'IR (297).

5. Bolomètre selon la revendication 4, dans lequel la couche réfléchissante (275) est formée à la base de l'absorbeur.

6. Bolomètre selon la revendication 5, dans lequel la couche réfléchissante (275) est constituée d'aluminium (Al).

7. Bolomètre selon la revendication 4, dans lequel le revêtement d'absorbeur d'IR (297) est formé au sommet de l'absorbeur.

8. Bolomètre selon la revendication 1, dans lequel la ligne de conduction (255) et le conduit électrique (262) sont constitués d'un métal.

9. Bolomètre selon la revendication 8, dans lequel la ligne de conduction (255) et le conduit électrique (262) sont constitués d'Al, de Pt ou de Ti.
